# EUROPEAN PATENT APPLICATION

(11) **EP 0 917 248 A2**
(43) Date of publication of application: **19.05.1999**
(21) Application number: 98121015.6
(22) Date of filing: 05.11.1998
(51) Int. Cl.: H01R 9/26

(54) **Interconnection and redistribution unit to connect electric and electronic control circuits on industrial machines**

(30) Priority: 12.11.1997 IT TO970986
(71) Applicant: COGIP S.R.L., 10090 Cascine Vica Rivoli (IT)
(72) Inventor: Teagno, Vladimiro, 10137 Torino (IT)

(57) **Abstract**

There is described an interconnection and redistribution unit (1) to connect electric and electronic control circuits on industrial machines, including: a plurality of connection means (19) adapted to be connected to corresponding multi-pole connectors (41); output connector means (3); and coupling means (5, 11, 13, 15) to secure said unit (1) in an operating position. The unit (1) is installed in the most suitable point to allow connection of actuators or users through connectors (41) and is connected through connector (3) to external handling units. An electronic circuit inside the unit (1) performs functions like switching and signalling the active functions.

## Description

The present invention refers to an interconnection and redistribution unit to connect electric and electronic control circuits on industrial machines. In particular, the present invention refers to the field of control circuits on industrial machines, for those applications where it is necessary to minimize the number of conductors and the related paths to obtain a plant rationalization and modularization.

The so-far known interconnection elements have such shapes and sizes that they can be placed with difficulty aboard an industrial machine; the known use of multiple circular connectors with ring nut and preassembled units with connectors of a predefined length creates a lot of problems when placing the element on available surfaces aboard the machine, and reduces the flexibility of use thereof for a user that must determine beforehand the lengths of all connectors to be used.

Object of the present invention is solving the above prior art problems, providing an interconnection unit with reduced encumbrance and modular shape.

A further object of the present invention is allowing the coupling of many units in a bank securing them to standard guides, for example of the DIN and OMEGA types, making the assembly very compact for an unlimited number of units.

A further object of the present invention is providing a dust- and liquid-airtight interconnection unit provided with multiple branch connectors able to be connected to wires directly by the user.

A further object of the present invention is providing a multiple connector with airtightness features and contacts to be welded or seamed directly by a user.

A further object of the present invention is providing a multi-pole connector that can be snap-coupled to a counterpart thereof in the interconnection unit.

A further object of the present invention is providing an integrated system consisting of an interconnection unit and of specific connectors that can be positively blocked against traction.

A further object of the present invention is providing a standard interconnection unit to be used with a PNP-NPN logics.

In general terms, therefore, the interconnection unit according to the present invention includes the units itself being realized in plastic material, an internal printed circuit with many parts having aboard multi-pole connectors, signalling LEDs, electronic components, a coupling spring for assembly on DIN- or OMEGA-type guides, a label-carrier plaque, cross-members for positively blocking the connectors, and a multi-pole connector for snap-coupling composed of many parts.

The interconnection unit appears as a module able to be composed, that can be used as single member applied parallely or orthogonally to the wall, or coupled into a bank, provided with multi-pole cable and branch connectors that can be connected to the upper side and to the lower side to the unit without them projecting as thickness from the interconnection unit itself.

The above and other objects and advantages of the invention, as will appear from the following description, are obtained by an interconnection unit as claimed in Claim l. Preferred embodiments and non-trivial variations of the present invention are claimed in the dependent Claims.

The present invention will be better described by some preferred embodiments thereof, given as a non-limiting example, with reference to the enclosed drawings, in which:
- Figure 1 is a side view of an embodiment of the interconnection unit of the present invention, completed with connectors, supported by a DIN-type guide;
- Figure 2 is a view similar to Fig. 1, wherein the interconnection unit is supported by an OMEGA-type guide;
- Figure 3 is an exploded perspective view of the interconnection unit in Fig. 1 and its related connectors;
- Figure 4 is a fragmentary perspective view inside the interconnection unit in Fig. 1;
- Figure 5 is a perspective view of the interconnection unit in Fig. 1 assembled in a bank on a DIN-type guide;
- Figure 6 is a perspective view of a multi-pole connector that can be applied to the interconnection unit of the present invention;
- Figure 7 is a fragmentary perspective view pointing out the parts composing the multi-pole connector in Fig. 6;
- Figure 8 is a side view similar to Fig. 1 that shows the connection of a single multi-pole connector to the interconnection unit;
- Figure 9 is a sectional view carried out on line IX-IX in Fig. 8; and
- Figure 10 is a circuit diagram that shows an embodiment of a function switching and control circuit.

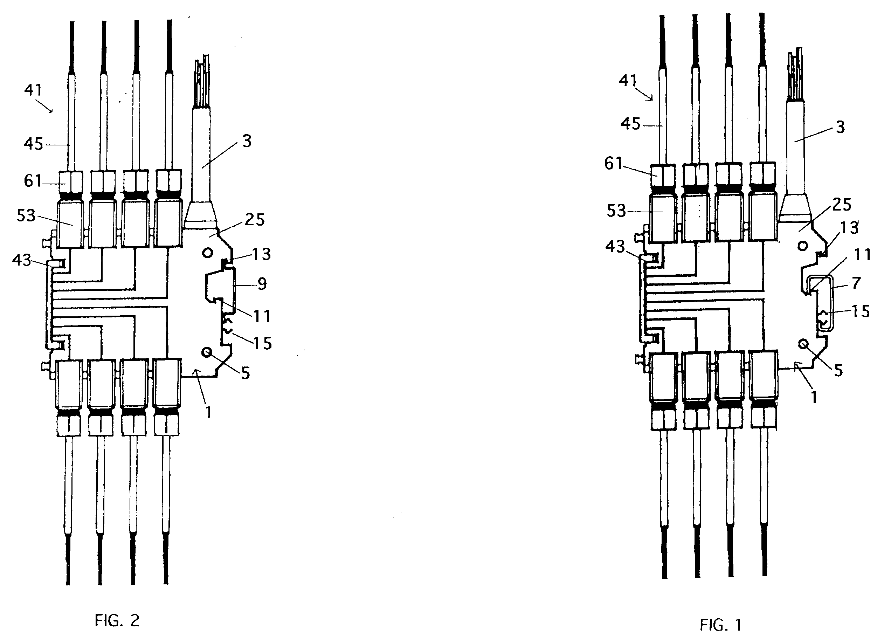

With reference first to Fig. 1 and 2, the interconnection unit 1 of the present invention is connected to an output cable 3 already upon factory assembling, according to the desired application. The interconnection unit 1 can be secured to a wall by using through-holes 5, or it can be coupled to a standard guide section bar, of the DIN type (designated as 7 in Fig. 1) or of the OMEGA type (designated as 9 in Fig. 2). Due to its particular shape, the interconnection unit 1 does not need modifications to carry out such type of coupling, and it will be hereinbelow described in its form as coupled to a guide section bar of the DIN type 7. Coupling to the above section bars is made possible by the presence of respective recesses 11 and 13 and of a symmetric spring 15, according to a coupling arrangement that is well shown in Fig. 1 and 2.

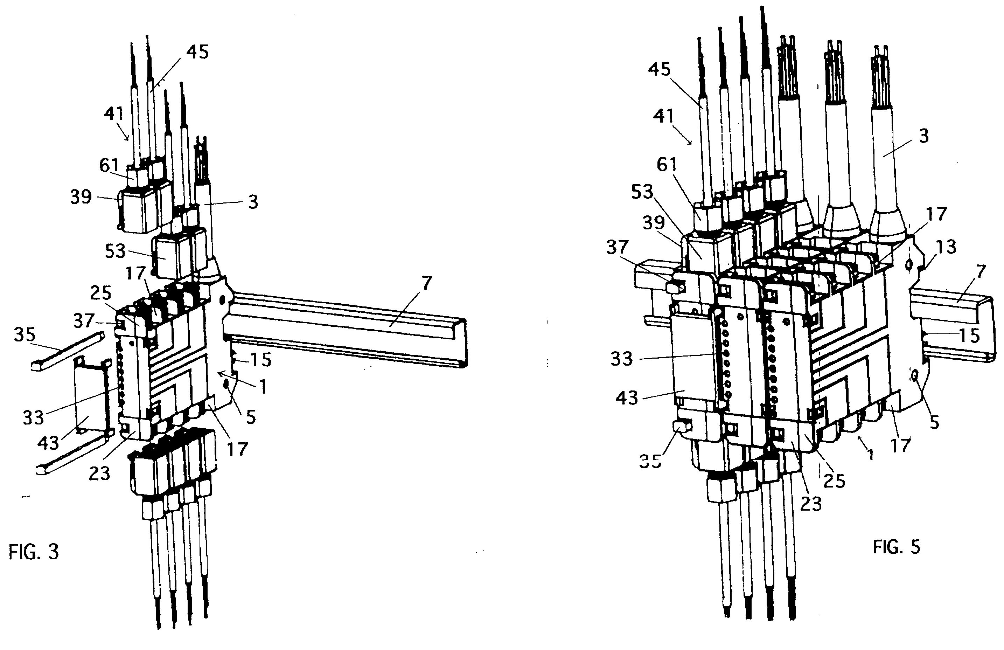

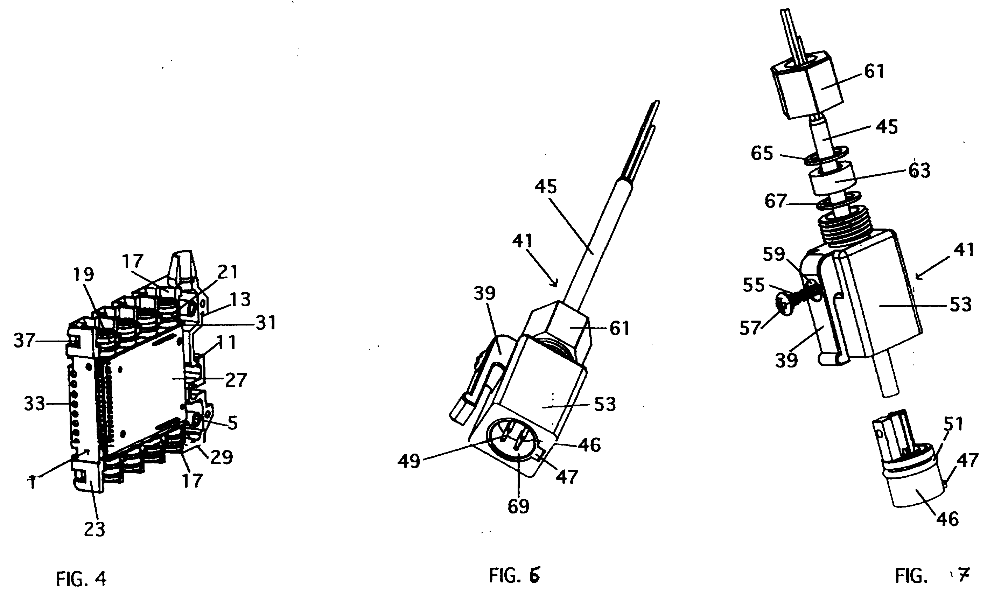

With particular reference to Fig. 3 and 4, the interconnection unit 1, that is preferably of a substantially boxed shape, is equipped on its upper side and on its lower side with a plurality of housings 17 in which a corresponding plurality of multi-pole cylindrical connectors 19 are placed, equipped with sealing rings 21.

Moreover, the interconnection unit 1 is composed of two shells 23 and 25, that contain therein a printed circuit composed of three parts 27, 29, 31, on which the suitably connected electronic components will be placed for the required functions and the signalling LEDs 32 that can be seen through holes 33.

Finally, the interconnection unit 1 is completed by keys 35 that, when inserted into cavities 37, prevent the elastic member deflection 39 of the connector 41 that will be connected to the interconnection unit 1, and then create a further mechanical locking of the inserted connectors 41. There is also a plaque 43 made of transparent plastic material that is snap-inserted in part of the front cavities 37.

Due to their particularly compact and linear configuration, the interconnection units 1 of the present invention, as better shown in Fig. 5, can be assembled in a bank on DIN (or OMEGA) section bars, allowing, in an extremely reduced space, to realize a high switching concentration of electric functions.

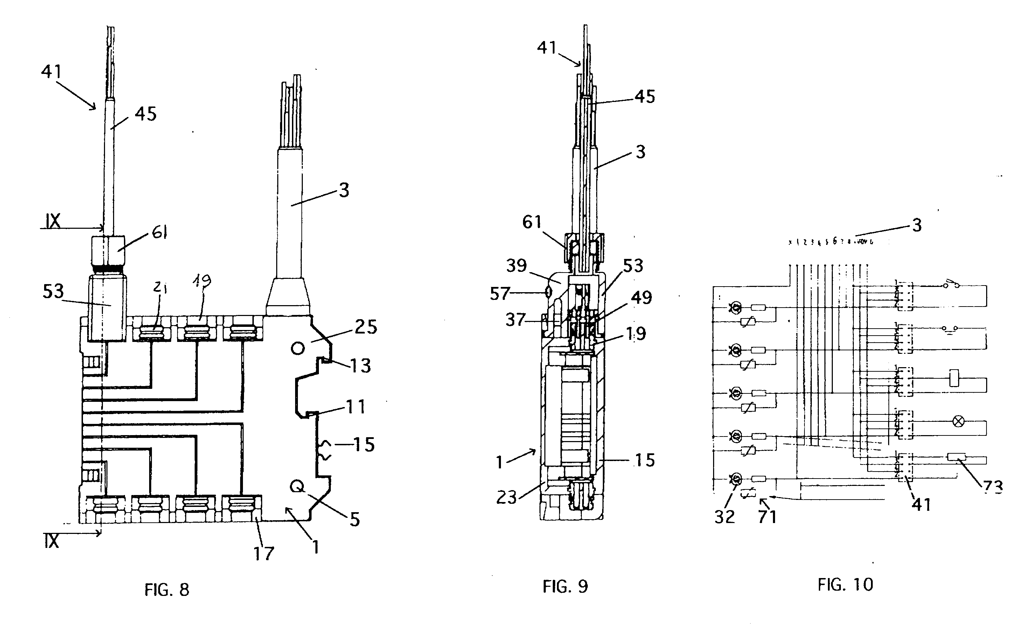

With reference now to Fig. 6 and 7, a preferred embodiment of the modular connector 41 will be described, such connector being connectable to the above interconnection unit 1. The connector 41, containing therein the real conductor 45, is equipped, as already seen, with a projecting resilient member 39 whose function is coupling to the interconnection unit 1 into the cavity 37. The internal contact-holder member 46, that can be removed, is equipped with a polarization 47 and guides the contacts 49 to be welded or seamed. A resilient sealing ring 51 is further provided, that realizes the airtightness between contact-holder member 45 and body 53 of connector 41. The contact-holder member 45 is kept in position by the screw 55, that makes the airtightness by means of the cone-shaped head 57 of the screw 55 itself and the cone-shaped seat 59 of the body 53.

Instead, the mechanical and airtight seal of the conductor 45 is realized by ring nut 61 that is screwed onto the body 53, compressing and expanding the gasket 63 interposed between two anti-friction metallic rings 65, 67. Finally, the airtight coupling of connector 41, when it is inserted into the interconnection unit 1, is realized with the corresponding sealing ring 21 of the multi-pole cylindric connectors 19, where such ring 21 engages the inside surface 69 of the contact-holder member 46.

The operation of the interconnection unit 1 of the present invention will now be described, with particular reference to Fig. 10, that shows a circuit diagram showing an embodiment of a function switching and control circuit.

After having prearranged the interconnection unit 1 with the output cable 3 being preinstalled and of a predefined length according to the application, this is connected (alone or in a bank) into the desired operating position, and the different modular connectors 41 are snap-inserted, always according to the application. In this way, an electric circuit controlling many users or actuators is divided into the most convenient point to optimize the laying of conductors aboard the industrial machine. Thereby, the interconnection unit 1 can be installed in the most suitable point to allow connecting the above actuators or users through specific multi-pole connectors 41 able to be connected. Finally, the output cable 3 is connected to multiple conductors of an handling unit (not shown), for example of the PLC type, to perform communications among the functions connected to the interconnection unit 1.

When operating, the control circuit included into the printed circuit boards 27, 29, 31 handles the desired functionalities for the different cables according to what is required by the application, for example as shown in Fig. 10. Here, a plurality of LEDs 32 are provided, these LEDs being each equipped with a respective filtering unit 71, connected on one side to the output interconnection cable 3, and on the other side to the plurality of connectors 41, each one of which is the terminal for a respective circuit 73. In Fig. 10, some types of circuit 73 have been shown as an example, but obviously numerous variations are possible that fall within the particular application for which these circuits 73 are provided. This and other equivalent embodiments of the switching and signalling circuit for the active function, make the interconnection unit 1 standard to be used with a logics both of the NPN and of the PNP type.

## Claims

1. Interconnection and redistribution unit (1) to connect electric and electronic control circuits on industrial machines, characterized in that it includes:
- a plurality of connection means (19) each one adapted to be connected to a corresponding one of a plurality of multi-pole connectors (41);
- output connector means (3); and
- coupling means (5, 11, 13, 15) to secure said unit (1) in an operating position.

2. Interconnection unit (1) according to Claim 1, characterized in that it further includes locking means (35) adapted to unmovably secure said plurality of connection means (19) into their respective housings (17) in said unit (1).

3. Interconnection unit (1) according to Claim 1 or 2, characterized in that it is of a substantially boxed shape, in that it is placed during operation with one of its lower sides downwards oriented, and in that it is connected to said plurality of multi-pole connectors (41) both on an upper side thereof, and on a lower side thereof, said multi-pole connectors (41) once having been connected remaining within the thickness emcumbrance limits of said unit (1).

4. Interconnection unit (1) according to any one of the previous Claims, characterized in that said coupling means (5, 11, 13, 15) are composed of:
- holes (5) adapted to contain wall-securing means;
- a recess (11) and a symmetric spring (15) adapted together to allow coupling said unit (1) to a guide section bar (7) of the DIN-type; and
- a recess (13) and said symmetric spring (15) adapted together to allow coupling said unit (1) to a guide section bar (9) of the OMEGA-type.

5. Interconnection unit (1) according to any one of the previous Claims, characterized in that it is able to be assembled in a bank in a plurality of similar adjoining units (1), said assembling being performed on a wall or on a guide section bar (7, 9) of the DIN or OMEGA type.

6. Interconnection unit (1) according to any one of the previous Claims, characterized in that each one of said plurality of multi-pole connectors (41) is equipped with resilient means (39) for the snap-connection to its own corresponding connection means (19) of said unit (1).

7. Interconnection unit (1) according to any one of the previous Claims, characterized in that it is equipped with an internal control circuit (27, 29, 31) adapted to perform switching and control of the functions of said unit (1), said control circuit (27, 29, 31) being able to be used with logics both of the NPN type and of the PNP type.

8. Interconnection unit (1) according to Claim 7, characterized in that it is further equipped with a plurality of signalling LEDs (32) connected to said control circuit (27, 29, 31) for the functions performed by said unit (1).

9. Interconnection unit (1) according to any one of the previous Claims, characterized in that said multi-pole connector (41) substantially comprises:
- an internal, removable contact-holder member (46), equipped with a polarization (47), said contact-holder member (46) guiding contacts (49) to be welded or seamed;
- a resilient sealing ring (51) between said contact-holder member (45) and the body (53) of the connector (41);
- a screw (55) for securing and airtight sealing said contact-holder member (46) to said body (53); and
- a ring nut (61) for mechanically and airtightly sealing the conductor (45) into the connector (41), said ring nut (61) being screwed onto said body (53) and compressing and expanding a gasket (63) interposed between two anti-friction metallic rings (65, 67).
